# EUROPEAN PATENT APPLICATION

(11) **EP 0 612 142 A2**
(43) Date of publication of application: **24.08.1994**
(21) Application number: 94850022.8
(22) Date of filing: 16.02.1994
(51) Int. Cl.: H03F 1/26, H03F 3/191

(54) **RF transistor harmonic trap**

(30) Priority: 18.02.1993 US 19221
(71) Applicant: TELEFONAKTIEBOLAGET LM ERICSSON, S-126 25 Stockholm (SE)
(72) Inventor: Moller, Thomas William, Morgan Hill, Ca. 95037 (US)
(74) Representative: Lövgren, Tage

(57) **Abstract**

A resonant circuit is used within an RF transistor package to significantly reduce the power level of an unwanted signal generated or amplified by the RF transistor without significantly affecting the performance of the RF transistor within its intended or specified range of operating frequencies. More particularly, an RF transistor device includes a multiplicity of parallel-connected transistors formed on a semiconductor chip and a chip carrier to which the semiconductor chip is bonded. A number of reactive elements are formed in contact with the chip carrier and connected to form a circuit network with the transistors. At least some of the reactive elements form a resonant trap to attenuate signals of a predetermined frequency range that would otherwise appear in an output signal of the circuit network.

## Description

### BACKGROUND OF THE INVENTION

### Field Of The Invention

The present invention relates to radio frequency (RF) transistors, and more particularly to apparatus for adjusting the frequency response of an RF transistor.

### State Of The Art

RF transistors are used in RF amplifiers to amplify RF signals. In radio communications applications, in order to facilitate broadcast of a signal over long distances, RF transistors are required to operate at high power levels, for example, 50W. In practice, an RF transistor is typically connected to impedance matching circuitry to allow for more convenient impedance matching, the RF transistor and the impedance matching circuitry together forming an RF stage. Hereinafter, the term "RF transistor" will be used to refer to such an RF stage.

Ideally, an RF transistor will, under appropriate operating conditions, produce as an output signal an exact replica of an input signal, amplified by a gain factor. In actual practice, however, the RF transistor produces unwanted signals including harmonics, half-frequency oscillations, intermodulation distortion, or some combination of the foregoing, resulting in an output signal that may differ significantly from the input signal. Filtering may be applied external to the RF transistor to reduce the unwanted signals. Such filtering is not always feasible or convenient, however, and can greatly increase the size and complexity of RF amplifiers. A need therefore exists for an RF transistor that enables the power level of an unwanted signal to be significantly reduced without significantly affecting the performance of the RF transistor within its intended range of operating frequencies.

### SUMMARY OF THE INVENTION

The present invention, generally speaking, uses a resonant circuit within an RF transistor package to significantly reduce the power level of an unwanted signal generated or amplified by the RF transistor without significantly affecting the performance of the RF transistor within its intended or specified range of operating frequencies. More particularly, an RF transistor device in accordance with the present invention includes a multiplicity of parallel-connected transistors formed on a semiconductor chip, and a chip carrier to which the semiconductor chip is bonded. A number of reactive elements are formed in contact with the chip carrier and connected to form a circuit network with the transistors. At least some of the reactive elements form a resonant trap to attenuate signals of a predetermined frequency range that would otherwise appear in an output signal of the circuit network.

### BRIEF DESCRIPTION OF THE DRAWINGS

The present invention may be further understood from the following description in conjunction with the appended drawings. In the drawings:
Figure 1 is a plan view of an RF transistor device in accordance with the present invention; and
Figure 2 is a schematic diagram of an equivalent circuit of the RF transistor device of Figure 1.

### DETAILED DESCRIPTION OF THE PREFERRED EMBODIMENTS

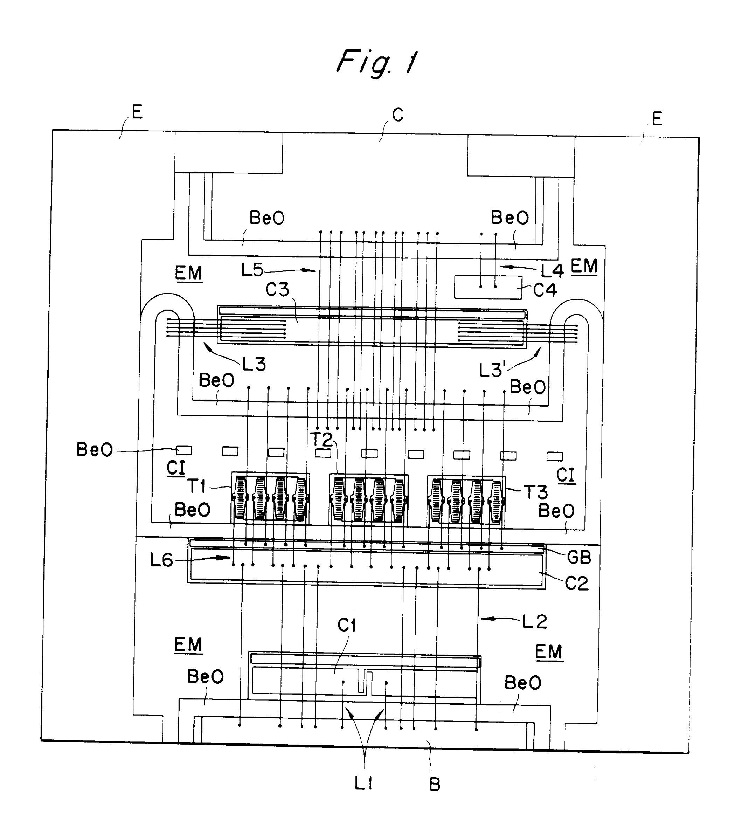

Referring now to Figure 1, an RF transistor device in accordance with an embodi ment of the present invention is formed on a substrate (for example, beryllium oxide, BeO) that is of very low electrical conductivity and very high thermal conductivity. On top of the insulating substrate is formed a metallization pattern. The metallization pattern includes four separate metallizations, a collector island Cl, a metallization EM surrounding the collector island, a lead connect for a base lead B, and a lead connect for a collector lead C. The metallization EM surrounding the collector island serves as a lead connect for emitter leads E. Areas of the substrate not covered with a metallization pattern have been labelled "BeO"in Figure 1.

Transistor dies T1, T2 and T3 and capacitor dies C1, C2, C3 and C4 are bonded to the metallization pattern, for example by eutectic bonding. The transistor dies are bonded to the collector island Cl, establishing a connection through the reverse side of the transistor dies between the collectors of the transistors and the collector island CI. The capacitor dies are bonded to the metallization EM surrounding the collector island. The base, collector and emitter leads B, C and E are bonded to their respect lead connects.

A complete electrical circuit is formed by connecting different parts of the structure with bonding wires, represented by pairs of black dots joined by line segments. The bonding wires may be, for example, gold wires approximately 2 mils in diameter. Each of the bonding wires presents to the circuit a distributed inductance. The distributed inductances associated with all of the bonding wires connecting the same parts of the structure may be modelled as a lumped inductance. The bonding wires therefore form inductors L1, L2, L3, L3', L4, L5, and L6 in Figure 1.

In the illustrated embodiment, each of the transistor dies T1 , T2and T3 contains four transistor cells, each transistor cell containing a host of parallel-connected transistors, for example of the silicon bipolar type. Each of the capacitor dies is a standard "chip capacitor" formed gold metallization layers adhered to the top and bottom of a dielectric layer of doped silicon using thin layers of silicon nitride. the gold layer may be shaped to adjust capacitance, to provide inductive current paths, and/or to provide multiple capacitors on a single chip. The capacitor may also contain a "ground bar", which is a short circuit from the top gold metallization to the bottom gold metallization. The ground bar provides a convenient ground that is unaffected by possible "eutectic wet-out", i.e., contamination from eutectic bonding.

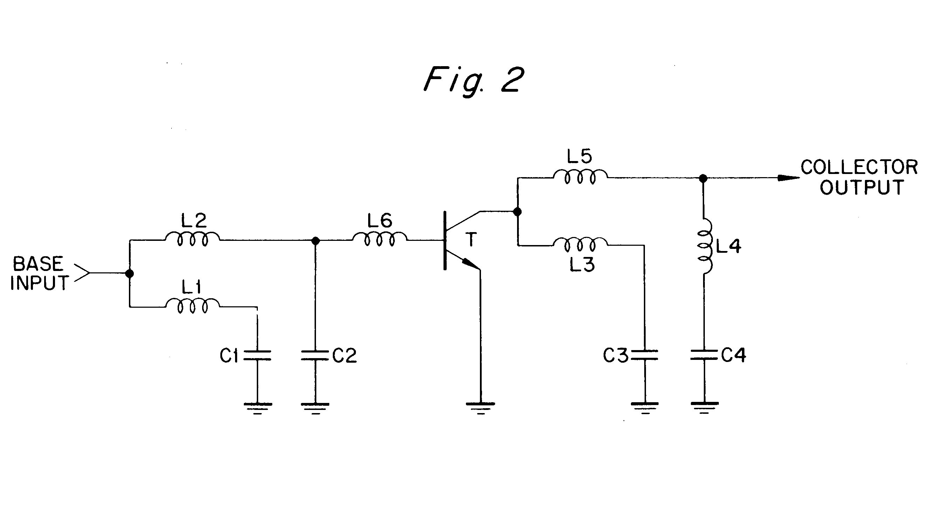

Referring to Figure 2, an equivalent circuit of the RF transistor device of Figure 1 is represented using the same designations as in Figure 1. Comparing Figures 1 and 2, observe that in Figure 1, the base lead B is connected by two short bonding wires L1 to the capacitor die C1 and is connected by eight longer bonding wires L2 to the capacitor die C2. In the present embodiment the RF transistor is designed to be connected in a common emitter configuration with the emitter leads E and the metallization EM being connected to ground. Accordingly, in Figure 2, the base input is connected through the series combination L1, C1 to ground and through the series combination L2, C2 to ground. The values of inductors L1 and L2, as with the values of the other inductors, are determined principally by the length and number of bonding wires used to connect one part of the circuit to another. The values of the capacitors C1 and C2, as with the values of the other capacitors in the circuit, are determined principally by the areas of their respective capacitor dies.

Referring again to Figure 1, the capacitor die C2 is connected by bonding wires L6 to the base electrodes of each transistor cell in the transistor dies T1, T2 and T3. The emitter electrode of each of the transistor cells is connected to a grounding bar GB on the capacitor die C2 and to the metallization EM on the substrate. The metallization EM is connected to ground by means of the emitter leads E to produce a common emitter configuration. Referring to Figure 2, therefore, the base of the transistorT is connected through the inductor L6 to the capacitor C2, and the emitter of the transistor T is connected to ground. For purposes of the present discussion, the inductance associated with the bonding wires connecting the emitter of each of the transistor cells to ground may be considered to be negligible.

Most significant to the present invention is output circuitry connected to the collector island Cl. The collector island is connected by bonding wires L3 to the capacitor die C3, and is connected by bonding wires L5 to the collector lead C. In Figure 2 therefore, the collector of the transistor C is connected through the inductor L5 to the collector output, and is connected through the series combination L3, C3 to ground. To remove unwanted signals that may be present at the collector output, the collector lead C is connected by bonding wires L4 to an add it ional capacitor die C4. As seen in Figure 2, the collector output is therefore connected through the series combination L4, C4 to ground. The series combination L4, C4 forms a resonant trap and is tuned to fitter out the unwanted signals. Although in the embodiment of Figure 1 a single, relatively simple trap structure is shown, the trap structure may be more finely tuned by connecting together additional capacitors and inductors to realize a multi-pole filter.

Furthermore, multiple independent trap structures may be provided. For example, one resonant trap circuit might be tuned to attenuate the even harmonics, and particularly the second harmonic, of a particular frequency of interest, and another trap structure might be tuned to attenuate the odd harmonics, particularly the third harmonic.

The described resonant trap may be readily and inexpensively realized without affecting performance of the remainder of the RF transistor device. Using the resonant trap, the size and complexity of RF amplifiers can be greatly reduced.

### Example

Two RF transistor devices of the type illustrated in Figure 1 were made using the techniques described, and then tested. One of the devices included a harmonic trap tuned to attenuate the third harmonic of an input frequency of approximately 900 MHz. The other device did not include a harmonic trap. Using a spectrum analyzer, in the case of the device not incorporating the harmonic trap, the signal strength of the third harmonic was found to be 32.8 dB below the fundamental frequency. In the case of the device incorporating the harmonic trap tuned to the third harmonic, the signal strength of the third harmonic was measured to be 54.7 dB below the fundamental frequency, more than a 20 dB improvement.

The foregoing has described the principles, preferred embodiments and modes of operation of the present invention. However, the invention should not be construed as limited to the particular embodiments discussed. Instead, the above described embodiments should be regarded as illustrative rather than restrictive, and it should be appreciated that variations may be made in those embodiments by workers skilled in the art without departing from the scope of the present invention as defined by the following claims.

## Claims

1. An RF transistor device comprising:
a multiplicity of parallel-connected transistors formed on a semiconductor chip:
a chip carrier to which said semiconductor chip is bonded; and
formed in contact with said chip carrier, a plurality of reactive elements connected to form a circuit network with said transistors, at least some of the reactive elements forming a resonant trap to attenuate signals of a predetermined frequency range that would otherwise appear in an output signal of the circuit network.
